# EUROPÄISCHE PATENTSCHRIFT

(11) **EP 1 356 518 B1**
(45) Veröffentlichungstag und Bekanntmachung des Hinweises auf die Patenterteilung: **06.03.2019**
(21) Anmeldenummer: 02701213.7
(22) Anmeldetag: 21.01.2002
(51) Int. Cl.: H01L 23/498

(54) **SUBSTRAT FÜR EIN ELEKTRISCHES BAUELEMENT UND VERFAHREN ZUR HERSTELLUNG**
SUBSTRATE FOR AN ELECTRIC COMPONENT AND METHOD FOR THE PRODUCTION THEREOF
SUBSTRAT POUR COMPOSANT ELECTRIQUE ET PROCEDE DE REALISATION

(30) Priorität: 01.02.2001 DE 10104574
(43) Veröffentlichungstag der Anmeldung: 29.10.2003
(73) Patentinhaber: SnapTrack, Inc., San Diego, CA 92121 (US)
(72) Erfinder: FEIERTAG, Gregor, 80637 München (DE); STELZL, Alois, 81549 München (DE); KRÜGER, Hans, 81737 München (DE)
(74) Vertreter: Wegner, Hans
(86) Internationale Anmeldenummer: PCT/DE2002/000180
(87) Internationale Veröffentlichungsnummer: WO 2002/061833

(56) Entgegenhaltungen:
- US-A- 5 904 563
- DONNAY ET AL: "Chip-Package Codesign of a Low Power 5-GHz RF Front End" PROC. OF IEEE, Bd. 88, Nr. 10, 10. Oktober 2000 (2000-10-10), Seiten 1583-1597, XP002238029 USA
- T BAIER: "Akustische Oberflächenwellenfilter-Schrittmacher der passiven Integration" ELEKTRONIK INDUSTRIE - BAUELEMENTE, [Online] 1. Oktober 2000 (2000-10-01), Seiten 48-53, XP002238030 Gefunden im Internet: <URL:http://dbindustrie.svhfi.securitas.ne t/AI/resources/32716bfd9ac.pdf> [gefunden am 2003-04-11]
- WONG C L ET AL: "Low cost flip chip bumping technologies" ELECTRONIC PACKAGING TECHNOLOGY CONFERENCE, 1997. PROCEEDINGS OF THE 1997 1ST SINGAPORE 8-10 OCT. 1997, NEW YORK, NY, USA,IEEE, US, 8. Oktober 1997 (1997-10-08), Seiten 244-250, XP010310000 ISBN: 0-7803-4157-0
- JUNG E ET AL: "Integration of Flip Chip Assembly in the SMT Process: Manufacturing and Productivity Issues" ELECTRONICS MANUFACTURING TECHNOLOGY SYMPOSIUM, 1998. TWENTY-THIRD IEEE/CPMT AUSTIN, TX, USA 19-21 OCT. 1998, NEW YORK, NY, USA,IEEE, US, 19. Oktober 1998 (1998-10-19), Seiten 8-15, XP010314075 ISBN: 0-7803-4523-1

## Beschreibung

Mit Hilfe der Flip-Chip-Technik gelingt es, Oberflächenwellenbauelemente in einfacher Weise auf einem Träger, beispielsweise einer Platine, zu befestigen und zu kontaktieren, das Bauelement dabei mechanisch geschützt anzuordnen und die gesamte Anordnung weiter in der Größe zu reduzieren. Dazu werden die piezoelektrischen Substrate, auf denen das Oberflächenwellenbauelement in Form von Metallisierungen realisiert ist, auf der Oberfläche mit lötfähigen Kontakten versehen. Auf einer Basisplatte, beispielsweise einer keramischen Mehrschichtplatte aus HTCC-Keramik sind entsprechende Gegenkontakte, die Lötpads vorgesehen. Diese Lötpads sind über Durchkontaktierungen in der Basisplatte angeordnet oder über metallische Leiterbahnen mit diesen verbunden, so dass der elektrische Anschluß an der Rückseite Basisplatte erfolgen kann. Mit nach unten weisenden Metallisierungen wird das Oberflächenwellensubstrat nun auf der Basisplatte montiert und mit Hilfe von Löthöckern - Bumps - die Verbindung zwischen den Lötpads und den lötfähigen Kontakten auf dem Chip hergestellt.

Die Bauelementstrukturen auf dem Chip bleiben dabei von der Basisplatte beabstandet und sind in dem zwischen Chip und Basisplatte gebildeten Zwischenraum mechanisch geschützt. Möglich ist es auch, die Bauelementstrukturen vor der Montage des Chips auf der Basisplatte mit Hilfe einer Abdeckung zu schützen, die beispielsweise in einem integrierten Verfahren aus zwei Lagen photostrukturierbaren Materials erzeugt werden kann. Damit werden die Bauelementstrukturen besser gegen Umgebungseinflüsse geschützt. Zur weiteren Versiegelung der Bauelemente ist es möglich, den Chip abzudecken, beispielsweise mit einer Folie oder einer Schicht, die im Randbereich dicht mit der Basisplatte abschließt. Mit Hilfe einer Metallschicht oder Metall-Teilschicht gelingt zusätzlich eine HF-Abschirmung des Oberflächenwellenbauelements.

Aus dem Artikel "Akustische Oberflächenwellenfilter - Schrittmacher der passiven Integration" Elektronik Industrie - Bauelemente, 1.10.2000, Seiten 48-53, XP002238030 von T. Baier ist ein CSSP genannter Bauelementaufbau bekannt, bei dem ein SAW Chip in Flipchiptechnik mittels Bumps auf einem hier zweischichtigen Chipträger aufgebracht ist.

Mit zunehmender Miniaturisierung von in Flip-Chip-Technik montierten Oberflächenwellenbauelementen steigen die Anforderungen an die Basisplatte und die verwendeten Aufbautechniken. Beispielsweise ist eine größere Anzahl von Bump-Verbindungen pro Flächeneinheit erforderlich, die mit herkömmlichen preiswerten Verfahren oft nicht mehr realisierbar sind. Die Aufbringung von Bumps und Leiterbahnen auf der Basisplatte erfolgte bislang in kostengünstiger Weise mittels Siebdruck. Damit können Bump-Abstände bis minimal 250 *µ*m und Bump-Durchmesser bzw. Leiterbahnbreiten von minimal 80 *µ*m erzeugt werden. Sollen noch kleinere Strukturen aufgedruckt werden, ist eine exakte Justierung der Strukturen auf der Basisplatte nicht mehr möglich. Dieses Problem wird dadurch verschärft, dass die Durchkontaktierungen der Basisplatte bereits im Stadium der keramischen Grünfolie erzeugt werden. Durch Sintern wird die Grünfolie dann in die endgültige feste Keramik überführt. Mit herkömmlich verwendeten HTCC-Keramiken geht dabei allerdings ein Flächenschwund einher, der einen Fehler von mehr als 0,2 % verursacht. Dies macht eine sichere Justierung von aufzudruckenden Bumps und Leiterbahnen unmöglich.

Aufgabe der vorliegenden Erfindung ist es daher, ein Substrat bzw. eine Basisplatte für in Flip-Chip-Technik aufzubringende Oberflächenwellenbauelemente anzugeben, welche bei weiter fortschreitender Miniaturisierung eine sichere Justierung der Bauelemente ermöglicht. Eine weitere Aufgabe besteht in der Herstellung eines solchen Substrats.

Diese Aufgabe wird erfindungsgemäß durch ein Substrat mit den Merkmalen von Anspruch 1 gelöst. Vorteilhafte Ausgestaltungen der Erfindung sowie ein Verfahren zur Herstellung des Substrats gegen aus weiteren Ansprüchen hervor.

Die Erfindung schlägt vor, als Substrat für Flip-Chipmontierte Bauelemente eine verzugsarme Keramik zu verwenden und die ggf. erforderlichen Leiterbahnen und Underbumpmetallisierungen (Lötpads) mit Hilfe einer Photostrukturierung in einem additiven oder subtraktiven Verfahren auf dem Substrat in Form einer Mehrschichtmetallisierung zu erzeugen und darüber Bumps aufzubringen.

Mit einem solchen Substrat gelingt es, die bisherigen Untergrenzen für Bump-Abstände von 250 *µ*m und von Bump- und Leiterbahndurchmessern von 80 *µ*m deutlich zu unterschreiten, so dass in einfacher Weise eine weitere Miniaturisierung von Bauelementen möglich ist. Mit der Erfindung können beispielsweise Bauelemente mit Außenabmessungen von 5 x 5 mm² oder besser hergestellt werden. Da die Erzeugung der Bumps auf einer erfindungsgemäßen photolithographisch erzeugten Underbumpmetallisierungen quasi selbstjustierend erfolgen kann, können Bumps für die spätere Flip-Chip-Montage einen Abstand von weniger als 100 *µ*m erzeugt werden. Dennoch ist es mit der Erfindung möglich, sämtliche Verarbeitungsschritte mit höherer Justiergenauigkeit durchzuführen, so dass das Bauelement mit hoher Zuverlässigkeit und mit wenig Ausschuß herstellbar ist.

Die erfindungsgemäß verwendete verzugsarme Keramik zeigt beim Sintern einen Schwund mit einem Fehler von weniger als 0,1 %, was im Rahmen der zulässigen Toleranzgrenzen eine sichere Justierung der Metallisierungen auf dem Substrat relativ zu den vor dem Sintern eingebrachten Durchkontaktierungen erlaubt. Eine besonders schwundarme Keramik ist beispielsweise eine ausgewählte non-shrinkage LTCC-Keramik (Low Temperature Cofired Ceramic).

Eine herkömmliche, beispielsweise durch Ausstanzen der Grünfolie erzeugte Durchkontaktierung weist üblicherweise Durchmesser von 150 *µ*m auf. In anspruchsvollen Verfahren lassen sich auch Durchkontaktierungen mit Durchmessern von 100 *µ*m oder gar 80 *µ*m erzeugen. Da ein erfindungsgemäßes Substrat jedoch Bump-Durchmesser von weniger als 75 *µ*m aufweisen kann, ist es vorteilhaft, die Lötpads zur Definition der Bumps nicht direkt auf dem Substrat zu erzeugen, sondern diese in einem Mehrschichtaufbau zu realisieren, welcher zumindest eine Isolationsschicht über dem Substrat und zumindest eine elektrisch leitende Schicht über der isolierenden Schicht umfaßt. In solchen Mehrschichtmetallisierungen lassen sich in einfacher Weise beliebige Verdrahtungsmuster und Lötpadgeometrien verwirklichen. Großflächige Anschlußflächen zur Kontaktierung der Durchkontaktierungen können so mit Isolationsschichten abgedeckt werden, über denen dann kleinflächigere Lötpads mit geringem Abstand als Underbumpmetallisierung erzeugt werden können. So gelingt eine Kompensation der durch das Keramiksubstrat verursachten Ungenauigkeiten, die kleinere Bumpabmessungen und -Abstände ermöglicht.

Die Isolationsschichten für die Mehrschichtmetallisierung sind vorzugsweise photostrukturierbar und besonders vorteilhaft als lichtempfindliche Photoresists eingestellt. Geeignete Basispolymere für diese photostrukturierbaren Isolationsschichten können die für Hochtemperaturbeständigkeit bekannten Polyimide, Polybenzoxazol (PBO) oder Benzocyclobuten (BCB) sein. Diese Polymere können entweder als negativ arbeitender Photoresist, welcher in bestrahlten Gebieten vernetzt, dabei unlöslich wird und seine thermische und chemische Resistenz erhöht, oder als Positivresist eingestellt sein, dessen Löslichkeit durch Bestrahlung erhöht werden kann.

Im additiven Verfahren werden die Metallisierungen mittels Photoresist oder photostrukturierbarer Isolationsschichten zunächst definiert. Dazu kann zunächst eine Grundmetallisierung aufgebracht werden, beispielsweise durch Sputtern oder Aufdampfen. Anschließend wird diese mit einer strukturierten Resistschicht oder Photoresistschicht abgedeckt, in der die zu metallisierenden Bereiche freigelegt sind. Zur Aufdickung der Grundmetallisierung werden in den freigelegten Bereichen die Metallisierungen aus der Lösung abgeschieden. Dazu eignen sich sowohl stromlose als auch galvanische Verfahren, die vorteilhafterweise auch kombiniert angewendet werden können. Eine Mehrschichtmetallisierung umfaßt z. B. eine Haft- oder Keimschicht, eine schnell wachsende Leitschicht und darüber üblicherweise eine Passivierungsschicht aus einem Metall, das oxidationsbeständig ist oder welches mittels dünner Oxidschicht versehen eine Eigenpassivierung zeigt. Für solche Metallisierungen sind eine Reihe von Verfahren bekannt, die jedoch nicht Gegenstand der Erfindung sind.

Im ebenfalls möglichen subtraktiven Verfahren werden die Metallisierungen durch Aufdampfen oder Sputtern zunächst ganzflächig in der gewünschten Schichtdicke aufgebracht und erst anschließend strukturiert, beispielsweise mittels Ätzen durch eine strukturierte Resistschicht als Ätzmaske.

Die exakte geometrische Definition der Metallisierungen in der photostrukturierbaren Schicht gelingt mittels bildhafter Belichtung, die mit einer entsprechend justierten Fotomaske durchgeführt werden kann. Möglich ist es jedoch auch, die Belichtung der photostrukturierbaren Schicht mittels scannender Laserbelichtung durchzuführen, die mit Hilfe von Orientierungsmarken auf dem Substrat selbstjustierend durchgeführt werden kann.

In einer Ausgestaltung der Erfindung ist es möglich, ein oder mehrere Durchkontaktierungen als Justierungsmarken für die selbstjustierende scannende Laserbelichtung zu verwenden. Dies garantiert eine exakte relative Positionierung der metallischen Strukturen auf dem Substrat relativ zu den bereits vorher vorhandenen Durchkontaktierungen.

Im folgenden wird die Erfindung anhand eines Ausführungsbeispiels und der dazugehörigen sieben Figuren näher erläutert.

Die Figuren zeigen anhand schematischer Querschnitte verschiedene Verfahrensstufen bei der Herstellung eines erfindungsgemäßen beispielsweise mit einem Oberflächenwellenbauelement bestückten Substrats.

Die Figuren dienen nur zum besseren Verständnis der Erfindung und stellen keine maßstabsgetreuen Abbildungen des Baulements dar.

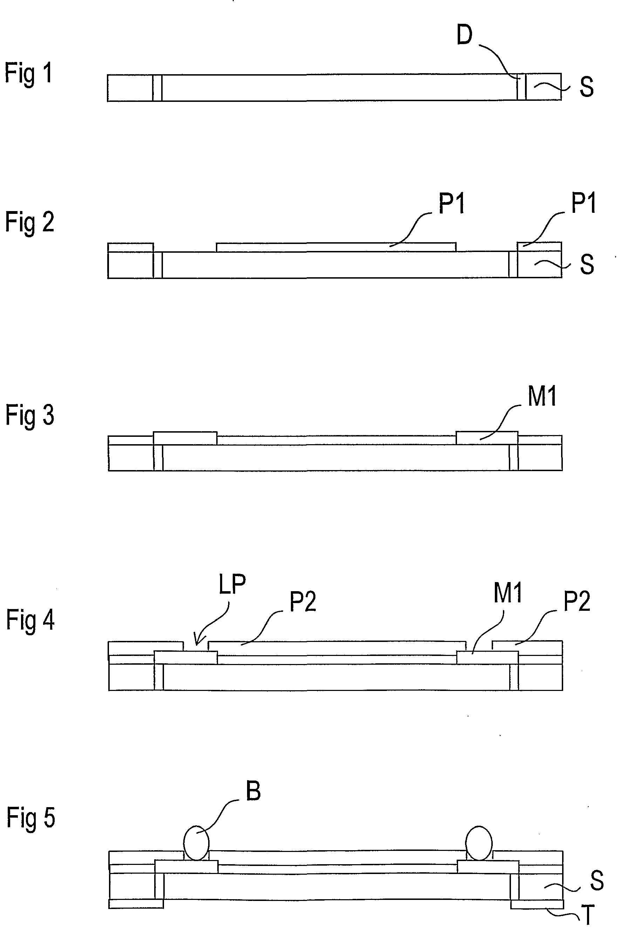

Eine keramische Grünfolie aus einem LTCC-Material wird beispielsweise durch Stanzen mit für äußere Anschlüsse erforderlichen Durchkontaktierungen D versehen. Die Folie wird gesintert, wobei sie einen exakt definierten lateralen Schwund mit einem Fehler von weniger als 0,1% aufweist. Figur 1 zeigt das mit den Durchkontaktierungen D versehene Substrat in diesem Zustand.

Auf dem Substrat S wird nun eine erste photostrukturierbare Schicht P1 ganzflächig aufgebracht und bildmäßig belichtet, um eine erste Metallisierungsschicht zu definieren. Die auch als spätere Isolationsschicht dienende photostrukturierbare Schicht P1 wird nach dem Entwickeln an den Stellen, die für die erste Metallisierung M1 vorgesehen sind, entfernt. Figur 2 zeigt die Anordnung mit der bereits photostrukturierten Schicht P1.

Für die Metallisierung wird hier mittels einer stromlosen Metallabscheidung und vorzugsweise galvanischer Verstärkung in den Bereichen, die nicht von der ersten photostrukturierbaren Schicht P1 bedeckt sind, eine dünne Metallschicht M1 abgeschieden, und zwar im Bereich erforderlicher Leiterbahnen und Lötpads (siehe Figur 3). Durch geeignete Abscheidebedingungen wird die Dicke der ersten Metallisierungsschicht M1 und zusammen mit der Metallauswahl deren Stromleitfähigkeit bestimmt.

Ganzflächig wird über der Anordnung nun eine zweite photostrukturierbare Schicht P2 aufgebracht. Durch Photostrukturierung werden die Flächen in der ersten Metallisierungsschicht M1 freigelegt, die Lötpads zur Aufnahme der Bumps, also die Underbump-Metallisierung darstellen. Figur 4 zeigt die Anordnung nach der Freilegung der als Lötpads LP vorgesehenen Bereiche der ersten Metallisierungsschicht M1.

Über den Lötpads LP werden nun die Bumps B erzeugt, vorzugsweise durch galvanische Abscheidung eines als Lot geeigneten Metalles oder einer Metallegierung, beispielsweise einer Blei/Zinnlegierung. Da bei der galvanischen Abscheidung die zweite photostrukturierbare Schicht P2 als Maske dient, ist das Verfahren zur Erzeugung der Bumps selbstjustierend. Für Bumpabmessungen zwischen 50 und 100µm ist auch Schablonendruck zum Erzeugen der Bumps geeignet.Figur 5 zeigt die Anordnung nach der Herstellung der Bumps B. Zusätzlich können in diesem Verfahrensstadium noch an der Rückseite des Substrats S noch die SMD-Metallisierungen T erzeugt werden, mit deren Hilfe das Substrat S später auf eine Platine aufgelötet werden kann.

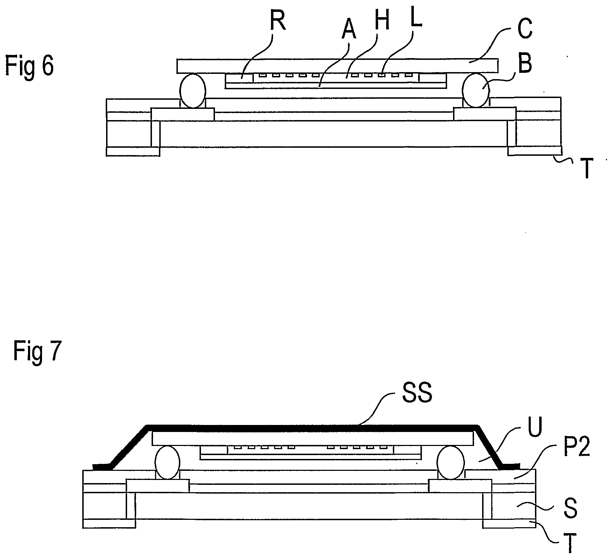

Auf das so fertig vorbereitete Substrat wird nun ein elektrisches Bauelement, z.B. ein Oberflächenwellenbauelement in Flip-Chip-Technik aufgelötet. Dazu wird der piezoelektrische Chip C, welcher an seiner Oberseite die Bauelementstrukturen in Form von elektrisch leitfähigen Strukturen L aufweist, mit zum Substrat S weisenden Bauelementstrukturen L auf die Bumps B aufgesetzt. Dazu weist der Chip C auf der (nach unten weisenden) Oberfläche lötfähige Metallisierungen auf, die die Anschlußmetallisierung für die Bauelementstrukturen L darstellen. Durch Aufschmelzen der Bumps B wird die Lötung durchgeführt. In Figur 6 ist die Anordnung mit dem auf dem Chip C realisierten Oberflächenwellenbauelement in diesem Stadium dargestellt. Zusätzlich zeigt Figur 6 eine von der Anmelderin als PROTEC bezeichnete Schutzabdeckung, welche wie eine Abdeckkappe über den Bauelementstrukturen L aufsetzt. Vorzugsweise besteht die Abdeckung aus einem die Bauelementstrukturen L umschließenden Rahmen R, welcher gleichzeitig Auflage und Abstandselement für die Abdeckschicht A darstellt. Auf diese Weise sind die Bauelementstrukturen L in einem Hohlraum H zwischen Abdeckung A und Chip C sicher untergebracht.

Obwohl mit der PROTEC-Abdeckung bereits ein hinreichender Schutz für die Bauelementstrukturen L gegen Umwelteinflüsse gegeben ist, kann der Chip C zusätzlich noch mit einer Schutzschicht SS abgedeckt werden. Diese liegt auf der Rückseite des Chips C auf und schließt am Rand mit der obersten Substratschicht P2 dicht ab. Die Schutzschicht SS kann eine ggf. mehrschichtige über das Bauelement gelegte Folie sein. Möglich ist es jedoch auch, die Schutzschicht auf dem Bauelement durch Materialabscheidung zu erzeugen und ggf. in den Randbereichen zu strukturieren. Dies kann unterstützt werden, wenn der Unterschnitt U zwischen dem Randbereich des Chips C und der Oberfläche des Substrats S mit einer fließfähigen Füllmasse verfüllt wird, auf die sich dann in einfacher Weise die Schutzschicht C als Schicht aufbringen läßt, beispielsweise durch Aufdampfen oder Aufsputtern eines Metalls.

Figur 7 zeigt das Bauelement mit der fertiggestellten Schutzschicht SS. Da sämtliche bisherigen Verfahrensschritte vorzugsweise im Nutzen durchgeführt wurden, bei dem auf einem großflächigen Substrat mehrere Chips in einem Arbeitsgang montiert werden, kann nun die Vereinzelung in einzelne Bauelemente erfolgen. Figur 7 stellt ein solches vereinzeltes Bauelement dar, welches effektiv gegen Umgebungseinflüsse, insbesondere mechanische Einwirkungen, Feuchtigkeit, Staub oder Chemikalien geschützt ist. Die Gesamtabmessungen des Bauelements sind nur wenig größer als die Oberfläche des Chips, sind daher äußerst platzsparend und werden von der Anmelderin als CSSP (Chip Size SAW Package) bezeichnet.

Obwohl nur anhand eines Ausführungsbeispiels beschrieben, ist die Erfindung nicht auf dieses beschränkt. Insbesondere ist es möglich, auch für das Substrat S einen Mehrschichtaufbau zu wählen, bei dem mehrere der dargestellten Grünfolien ggf. unter der Dazwischenanordnung von Leiterbahnstrukturen zu einem dickeren mehrschichtigen Substrat vereinigt werden können. Auch der Aufbau der Metallisierungen auf der Oberfläche des Substrats muß nicht der dargestellten Form genügen. Möglich ist es auch, weitere Metallisierungsschichten von beliebiger Struktur und Dicke zu erzeugen. Letztlich kann dies der besseren Justierung der Lötpads dienen, über denen schließlich selbstjustierend die Bumps erzeugt werden. Der Oberflächenwellenchip kann eine oder mehrere PROTEC Abdeckungen aufweisen, kann aber auch ohne diese Abdeckung auf dem Substrat montiert werden. Es kann auch ein ein anderes Bauelement auf diese Weise verarbeitet, montiert und geschützt werden, beispielsweise ein IC oder auch ein passives Bauelement. Die Schutzschicht SS kann ein- und mehrschichtig sein, wobei eine oder mehrere dieser Schichten eine Metallschicht umfassen können. Außerdem ist es möglich, das gesamte Bauelement oberhalb der Schutzschicht SS noch mit einem Gießharz abzudecken oder mit einer Kunststoffmasse zu umspritzen, was dem weiteren Schutz des Bauelements dient.

## Patentansprüche

1. Substrat mit darauf in Flip-Chip Technik mittels Bumps (B) montiertem Oberflächenwellenbauelement (C),
bei dem,
- das Substrat (S) zumindest eine Schicht einer gesinterten LTCC Keramik (Low Temperature Cofired Ceramic) umfasst,
- Durchkontaktierungen (D) durch die zumindest eine Schicht vorgesehen sind,
- über den Durchkontaktierungen (D) eine erste Metallisierung (M1) in Form großflächiger Anschlussflächen angeordnet ist,
- das Substrat und die Anschlussflächen auf der dem Oberflächenwellenbauelement zugewandten Seite mit einer photostrukturierbaren Polymerschicht (P2) abgedeckt sind, in der Öffnungen angeordnet sind, die kleinflächiger als die Anschlussflächen sind,
- Underbumpmetallisierungen (LP) in den Öffnungen vorgesehen sind, wobei die Underbumpmetallisierungen (LP) durch einen Teil der Anschlussflächen gebildet werden und damit auch mit den Durchkontaktierungen (D) verbunden sind, und
- die Bumps (B) galvanisch oder stromlos über den Underbumpmetallisierungen (LP) abgeschieden sind, wobei der Durchmesser der Bumps (B) weniger als 75 µm beträgt,
- auf den Bumps in Flip-Chip Technik das Oberflächenwellenbauelement (C) mit zum Substrat weisenden Bauelementstrukturen (L) und lötfähigen Metallisierungen montiert ist,
- über dem Oberflächenwellenbauelement (C) eine Abdeckung (A) aufgebracht ist, wobei die Polymerschicht (P2) als Isolierschicht auf dem Substrat (S) verbleibt.

2. Substrat nach Anspruch 1,
bei dem das Oberflächenwellenbauelement (C) zusätzlich noch mit einer Schutzschicht (SS) abgedeckt ist, die ausgewählt ist aus einer ein- oder mehrschichtigen über das Oberflächenwellenbauelement gelegten Folie oder einer durch Materialabscheidung erzeugten Schutzschicht.

3. Substrat nach einem der Ansprüche 1 bis 2,
bei dem der Durchmesser der Bumps (B) geringer ist als der Durchmesser der Durchkontaktierung (D).

4. Verfahren zur Herstellung eines Substrats (S) mit einem darauf in Flip-Chip Technik mittels Bumps (B) montiertem Oberflächenwellenbauelemente (C),
- bei dem in einer keramischen Grünfolie aus einem LTCC Material (Low Temperature Cofired Ceramic) Öffnungen für Durchkontaktierungen (D) erzeugt werden,
- bei dem die Grünfolie gesintert wird, um das Substrat (S) zu herstellen,
- bei dem auf der Oberfläche des Substrats (S) mittels einer Photostrukturierung relativ großflächige metallisierte Anschlussflächen (M1) über den Durchkontaktierungen (D) erzeugt werden,
- bei dem auf das Substrat (S) und die Anschlussflächen (M1) zumindest eine photostrukturierbare isolierende Polymerschicht (P2) aufgebracht wird und darin über den Anschlussflächen Öffnungen definiert werden, die kleinflächiger als die Anschlussflächen (M1) sind,
- bei dem in den Öffnungen die Metallisierung der Anschlussflächen Underbumpmetallisierungen (LP) definieren,
- bei dem über der Underbumpmetallisierungen (LP) in einem galvanischen oder stromlosen Verfahren Bumps (B) erzeugt werden, wobei der Durchmesser der Bumps (B) weniger als 75 µm beträgt,
- bei dem auf die Bumps (B) ein Oberflächenwellenbauelement (C) mit zum Substrat weisenden Oberflächenwellenbauelementstrukturen (L) und lötfähigen Metallisierungen aufgesetzt und verlötet wird, wobei die zumindest eine photostrukturierbare Polymerschicht (P2) auf dem Substrat (S) verbleibt.

5. Verfahren nach Anspruch 4,
- bei dem mehrere Grünfolien mit dazwischen angeordneten Leiterbahnen vor dem Sintern zu einem mehrschichtigen Aufbau (S) vereinigt werden.

6. Verfahren nach Anspruch 4 oder 5, bei dem zusammen mit den Anschlussflächen (M1) Leiterbahnen definiert und erzeugt werden.

7. Verfahren nach einem der Ansprüche 4 bis 6,
bei dem zur Photostrukturierung ganzflächig eine Photolackschicht (P1) aufgebracht, bildhaft belichtet und anschließend entwickelt wird.

8. Verfahren nach Anspruch 7,
bei dem zur bildhaften Belichtung der Photolackschicht (p1) eine scannende Laserbelichtung durchgeführt wird.

9. Verfahren nach Anspruch 8,
bei dem eine selbstjustierende scannende Laserbelichtung durchgeführt wird, wobei als Justiermarken die Durchkontaktierungen (D) verwendet werden.

10. Verfahren nach einem der Ansprüche 4 bis 9,
bei dem Leiterbahnen und Lötpads (LP) in einem Mehrschichtaufbau (M1) realisiert werden, für den zumindest eine isolierende Schicht (P1, P2) und eine leitfähige Schicht (M1) übereinander erzeugt werden.

11. Verfahren nach Anspruch 10,
bei dem die zumindest eine isolierende Schicht (P1, P2), die für den Mehrschichtaufbau verwendet wird, photostrukturierbar ist und ausgewählt ist aus Polyimid, Polybenzoxazol oder Benzobicyclobuten.

## Claims

1. Substrate with a surface wave component (C) mounted thereon in flip-chip technique by means of bumps (B),
wherein,
- the substrate (S) comprises at least one layer of sintered LTCC ceramic (Low Temperature Cofired Ceramic),
- vias (D) are provided through the at least one layer,
- a first metallization (M1) in the form of large-area connection surfaces is arranged above the vias (D),
- the substrate and the connection surfaces are covered on the side facing the surface wave component with a photostructurable polymer layer (P2) in which openings are arranged which are smaller than the connection surfaces,
- underbump metallizations (LP) are provided in the openings, the underbump metallizations (LP) being formed by a part of the connection surfaces and thus also being connected to the vias (D), and
- the bumps (B) are galvanically or without current deposited over the underbump metallizations (LP), wherein the diameter of the bumps (B) is less than 75µm,
- the surface wave component (C) is mounted using flip-chip technique on the bumps, wherein the component C comprises component structures (L) facing the substrate and solderable metallizations,
- a cover (A) is arranged over the surface wave component (C), wherein the polymer layer (P2) remains on the substrate (S) as an insulating layer.

2. Substrate according to claim 1,
wherein the surface wave component (C) is additionally covered with a protective layer (SS) selected from a single-layer or multi-layer film laid over the surface wave component or a protective layer produced by material deposition.

3. Substrate according to any of claims 1 to 2,
wherein the diameter of the bumps (B) is smaller than the diameter of the via (D).

4. Method of manufacturing a substrate (S) comprising a surface wave component (C) mounted in flip-chip technique by means of bumps (B),
- wherein openings for vias (D) are produced in a ceramic green foil made from a LTCC material (Low Temperature Cofired Ceramic),
- wherein the green foil is sintered to produce the substrate (S),
- wherein relatively large metallized connecting surfaces (M1) are created on the surface of the substrate above the vias (D) by means of photostructuring,
- wherein at least a photostructurable, insulting polymer layer (P2) is applied to the substrate (S) and to the connection surfaces (M1) and openings are defined therein which are smaller than the connecting surfaces (M1),
- wherein the metallization of the connection surfaces defines the underbump metallizations (LP) in the openings,
- wherein bumps (B) are generated over the underbump metallizations (LP) in a galvanic or currentless process, wherein the diameter of the bumps (B) is less than 75µm,
- wherein a surface wave component (C) comprising component structures (L) facing the substrate and comprising solderable metallizations is placed and soldered onto the bumps (B), wherein the at least one photostructurable polymer layer (P2) remains on the substrate (S).

5. Method according to claim 4,
wherein several green foils with conductor tracks arranged between them are combined to a multilayer structure (S) before sintering.

6. Method according to claim 4 or 5,
wherein conductor tracks are defined and created together with the connection surfaces (M1).

7. Method according to any of claims 4 to 6,
wherein for the purpose of photostructuring, a photoresist layer (P1) is applied over the entire surface, is exposed as an image and is then developed.

8. Method according to claim 7,
wherein a scanning laser exposure is performed to expose the photoresist layer (P1) as an image.

9. Method according to claim 8,
wherein a self-adjusting scanning laser exposure is performed, wherein the vias (D) being used as adjustment marks.

10. Method according to any of claims 4 to 9,
wherein conductor tracks and solder pads (LP) are realized in a multilayer structure (M1), for which at least one insulating layer (P1, P2) and a conductive layer (M1) are produced one above the other.

11. Method according to claim 10,
wherein the at least one insulating layer (P1, P2) used for the multi-layer structure is photostructurable and is selected from polyimide, polybenzoxazole or benzobicyclobutene.

## Revendications

1. Substrat comportant un composant à ondes de surface (C) monté sur celui-ci en technique flip-chip par des plots (B) ;
dans lequel
- le substrat (S) comprend au moins une couche d'une céramique frittée LTCC (Low Temperature Cofired Ceramic),
- des traversées de contact (D) sont prévues à travers l'au moins une couche,
- une première métallisation (M1) sous la forme de surfaces de connexion de grande surface est disposée au-dessus des traversées de contact (D),
- le substrat et les surfaces de connexion sont recouverts d'une couche de polymère photostructurable (P2), dans laquelle sont formées des ouvertures de plus petite surface que les surfaces de connexion, sur la face tournée vers le composant à onde de surface,
- des métallisations de sous-plot (LP) sont prévues dans les ouvertures, les métallisations de sous-plot (LP) étant formées par une partie des surfaces de connexion et étant ainsi liées également aux traversées de contact (D), et
- les plots (B) sont déposées par voie galvanique ou sans courant au-dessus des métallisations de sous-plot (LP), le diamètre des plots (B) étant inférieur à 75 µm,
- le composant à ondes de surface (C) est monté sur les plots en technique flip-chip avec des métallisations aptes au brasage et des structures de composant (L) tournées vers le substrat,
- un recouvrement (A) est déposé au-dessus du composant à onde de surface (C), la couche de polymère (P2) restant sur le substrat (S) en tant que couche isolante.

2. Substrat selon la revendication 1,
dans lequel le composant à ondes de surface (C) est recouvert en outre d'une couche protectrice (SS) choisie parmi une feuille mono- ou multicouche placée au-dessus du composant à ondes de surface ou une couche protectrice formée par dépôt de matière.

3. Substrat selon l'une des revendications 1 à 2,
dans lequel le diamètre des plots (B) est inférieur au diamètre de la traversée de contact (D).

4. Procédé de fabrication d'un substrat (S) comportant un composant à onde de surface (C) monté sur celui-ci à l'aide de plots (B) par la technique flip-chip ;
- dans lequel des ouvertures pour des traversées de contact (D) sont formées dans une feuille crue en céramique à partir d'un matériau LTCC (Low Temperature Cofired Ceramic),
- dans lequel la feuille crue est frittée pour fabriquer le substrat (S),
- dans lequel des surfaces de connexion métallisées (M1) ayant des surfaces relativement grandes sont formées au-dessus des traversées de contact (D) sur la surface du substrat (S) à l'aide d'une photostructuration,
- dans lequel au moins une couche de polymère photostructurable (P2) isolante est déposée sur le substrat et sur les surfaces de connexion (M1) et des ouvertures de plus petites surfaces que les surfaces de connexion (M1) sont définies dans celle-ci au-dessus des surfaces de connexion,
- dans lequel la métallisation des surfaces de connexion définit des métallisations de sous-plot (LP) dans les ouvertures,
- dans lequel des plots (B) sont formés au-dessus des métallisations de sous-plot (LP) par un procédé galvanique ou sans courant, le diamètre des plots (B) étant inférieur à 75 µm,
- dans lequel un composant à ondes de surface (C) ayant des structures de composant à ondes de surface (L) tournées vers le substrat et des métallisations aptes au brasage est placé sur les plots (B) et brasé, l'au moins une couche de polymère photostructurable (P2) restant sur le substrat (S).

5. Procédé selon la revendication 4,
dans lequel plusieurs feuilles crues sont réunies avant le frittage en une structure multicouche (S) avec des pistes conductrices disposées entre elles.

6. Procédé selon la revendication 4 ou 5,
dans lequel des pistes conductrices sont définies et formées conjointement avec les surfaces de connexion (M1).

7. Procédé selon l'une des revendications 4 à 6,
dans lequel une couche de résine photosensible (P1) est déposée sur toute la surface pour la photostructuration, est exposée pour former une image et est ensuite développée.

8. Procédé selon la revendication 7,
dans lequel une exposition laser à balayage est réalisée pour l'exposition de la couche de résine photosensible (P1) en vue de former une image.

9. Procédé selon la revendication 8,
dans lequel une exposition autoalignante à balayage laser est réalisée, les traversées de contact (D) étant utilisées comme marques d'alignement.

10. Procédé selon l'une des revendications 4 à 9,
dans lequel des pistes conductrices et des points de brasure (LP) sont réalisés dans une structure multicouche (M1) pour laquelle au moins une couche isolante (P1, P2) et une couche conductrice (M1) sont formées l'une sur l'autre.

11. Procédé selon la revendication 10,
dans lequel l'au moins une couche isolante (P1, P2) utilisée pour la structure multicouche est photostructurable et est choisie parmi un polyimide, un polybenzoxazole ou un benzobicyclobutène.
